(19) Europäisches Patentamt
European Patent Office
Office européen des brevets

(11) **EP 2 171 483 B1**

(12) **FASCICULE DE BREVET EUROPEEN**

(45) Date de publication et mention
de la délivrance du brevet:
**12.01.2011 Bulletin 2011/02**

(21) Numéro de dépôt: **08827954.2**

(22) Date de dépôt: **10.07.2008**

(51) Int Cl.:
*G01R 15/18* *(2006.01)*   *G01R 19/20* *(2006.01)*

(86) Numéro de dépôt international:
**PCT/FR2008/051298**

(87) Numéro de publication internationale:
**WO 2009/024692 (26.02.2009 Gazette 2009/09)**

(54) **CAPTEUR DE COURANT PERFECTIONNÉ**

VERBESSERTER STROMSENSOR

IMPROVED CURRENT SENSOR

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **19.07.2007 FR 0756599**

(43) Date de publication de la demande:
**07.04.2010 Bulletin 2010/14**

(73) Titulaire: **AIRBUS OPERATIONS (S.A.S)**
**31060 Toulouse (FR)**

(72) Inventeurs:
• **ROUSSET, David**
**F-31300 Toulouse (FR)**

• **DAVY, Arnaud**
**F-31140 Pechbonnieu (FR)**

(74) Mandataire: **Schmit, Christian Norbert Marie**
**Schmit-Chretien SNC**
**8 place du Ponceau**
**95031 Cergy Pontoise Cedex (FR)**

(56) Documents cités:
**WO-A-2007/005578    DE-A1- 2 920 484**
**DE-A1- 19 642 472    JP-A- 2 287 266**
**JP-A- 4 064 068    US-A- 4 529 931**
**US-A- 5 223 789**

## Description

L'invention a pour objet un capteur de courant perfectionné isolé et adapté aux dispositifs asservis de l'électronique de puissance embarquée avionique.

Le domaine de l'invention est celui des capteurs de courant. Plus particulièrement le domaine de l'invention est celui de l'asservissement/commande de dispositifs de l'électronique de puissance qui se développent de façon importante dans l'aéronautique, l'automobile, le ferroviaire et l'énergie. Dans ces systèmes électroniques, la mesure de la grandeur physique « courant » est en effet une variable de commande qu'il convient de mesurer afin de piloter le dispositif.

Un but de l'invention est de fournir un capteur adapté à l'environnement avionique et en particulier un capteur supportant bien d'importante variation de températures.

Un autre but de l'invention est de fournir un capteur ayant une grande plage d'utilisation.

Encore un autre but de l'invention est de fournir un capteur ayant une bonne linéarité.

Dans l'état de la technique on connaît plusieurs dispositifs comme décrits, par exemple, par DE 29 20 484, JP 04 064 068 et US 4 529 931, servant à effectuer des mesures de courant et étant intégrés dans des boucles de contrôle de dispositifs électroniques.

La façon la plus évidente de mesurer un courant est celle du shunt résistif qui consiste à employer en parallèle une résistance de faible valeur et de mesurer la tension à ces bornes. D'apparence simple, cette méthode n'est pas complètement satisfaisante.

Les courants à mesurer circulent dans des conducteurs sous haute tension (centaines de volts), et il n'est pas facile d'extraire cette mesure et de la ramener au niveau de la masse électrique.

Un amplificateur d'isolement est souvent nécessaire. Alors l'électronique associée se complique rapidement (alimentation secondaire référencée au potentiel du conducteur, transformateur).

Une résistance est un élément à forte dissipation thermique. Pour effectuer une mesure de courant on la choisit généralement de faible valeur pour minimiser les pertes par dissipation, mais survient alors l'inconvénient d'avoir à mesurer de très faibles valeurs de tensions (de l'ordre de quelques millivolts) pour les faibles courants, ce qui occasionne une perte significative de précision. Il devient alors nécessaire de faire un compromis entre précision et pertes du à la résistance de mesure. Avec cette solution il faut donc adapter le dispositif de mesure à chaque utilisation.

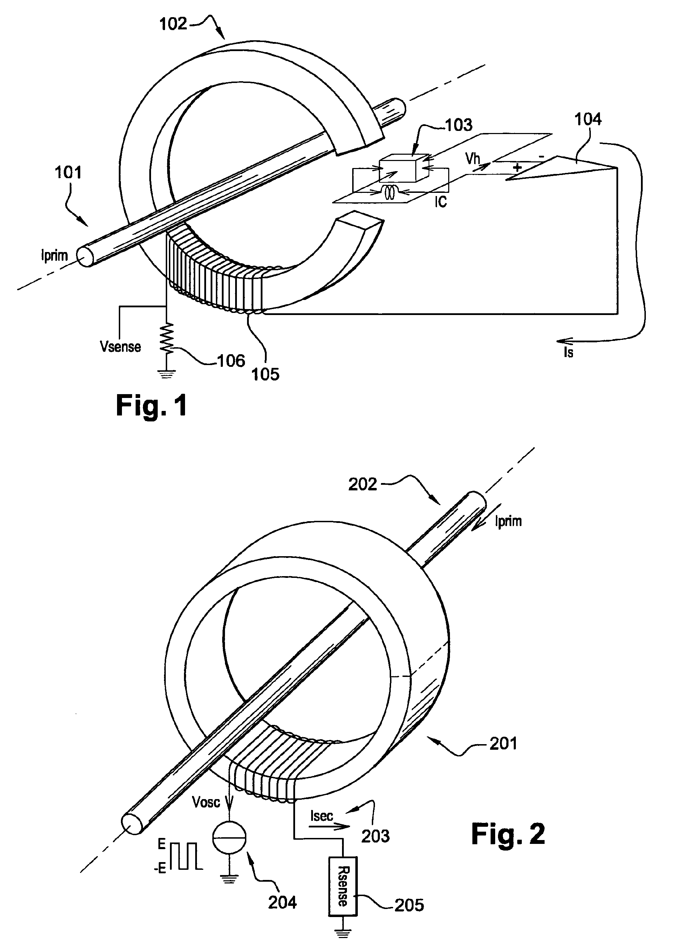

Une autre solution de l'état de la technique est la mesure de courant par capteur à effet hall en boucle fermé. La figure 1 illustre cette solution.

Soit un conducteur 101 principal traversé par un courant à mesurer Iprim. Le conducteur principal passe dans un tore 102 magnétique dont le rôle est de concentrer les lignes de champ créées par le passage du courant *Iprim* dans le conducteur 101 principal.

Une pastille 103 à effet Hall est incluse dans un entrefer pratiqué dans le circuit magnétique. La pastille à effet Hall crée une tension *Vh* proportionnelle à: la densité de flux magnétique B, le courant *Ic,* et une constante dite constante de Hall. Cette tension *Vh* est amplifiée par un amplificateur 104 et transformée en un courant *Is* proportionnel.

Un enroulement 105 secondaire de Ns spires reçoit le courant *Is*. Il est dit enroulement de compensation, car traversé par le courant *Is* il va s'opposer aux ampères-tours créés dans le tore par le conducteur principal de façon à avoir : Ns* Is - Nprim*Iprim=0

L'expression finale de *Vsense,* mesurée aux bornes d'une résistance 106 de mesure et point de mesure en fonction de la grandeur *Iprim* est :

$$V\text{int} = Rsense \cdot \frac{Nprim}{Ns} \cdot Iprim$$

Ces capteurs à effet hall présentent cependant des limitations rendant leurs usages complexes dans certains environnements. Parmi ces limitations on cite au moins les suivantes:

- Risque d'offset magnétique en cas de sur courant. Cette surcharge peut entraîner une saturation accidentelle due au champ rémanent du matériau magnétique. Ceci a pour conséquence de détériorer la précision du capteur. Il faut alors le démagnétiser. Il faut donc prévoir des maintenances fréquentes en ce sens.

- De façon générale ce capteur est très sensible aux variations de température. Les constantes de calcul liant le champ B à la tension *Vh* dans la cellule à effet Hall varie en fonction de la température. La cellule induit également des tensions de décalage, ce qui provoque des imprécisions au voisinage du zéro de courant

Dans l'invention on résout ces problèmes par la mise en oeuvre d'un dispositif comportant un tore magnétique partiellement bobiné, les enroulements de ce bobinage étant alimentés par un oscillateur. La figure 2 illustre un mode de réalisation générique de l'invention.

La figure 2 montre un tore 201 magnétique caractérisé par ses dimensions géométriques, *Le* sa longueur effective, et *Ae* son aire effective. Ce tore est également caractérisé par ses propriétés magnétiques décrites par son cycle d'hystérésis *B*=fct(H). *B* est la densité de flux dans le matériau magnétique, *H* est le champ magnétique.

La figure 2 montre aussi un conducteur 202 primaire dans lequel circule un courant Iprim. Ce conducteur effectue Nprim tours autour du tore. Dans l'exemple de la figure 2 Nprim vaut 1

Soit un conducteur 203 secondaire, appelé enroulement excitateur, ce conducteur est connecté d'une part à un générateur 204 de signaux carrés, et d'autre par à une résistance 205 (de valeur Rsense) permettant la mesure du courant Isec. Cet enroulement comporte un nombre Nsec de tours (généralement autour du millier).

Le générateur 204 de tension de signaux carré délivre une tension carrée Vosc qui bascule entre les tensions +E et -E. Le rôle de ce générateur est de porter alternativement le matériau magnétique en saturation de +Bsat à -Bsat (soit l'excursion de densité de flux magnétique $\Delta B$) à une fréquence Fosc.

Dans ces conditions le courant observé Isec va suivre, avec retard, de manière continue et selon une courbe connue, l'évolution de la tension Vosc.

Si aucun courant ne circule dans le conducteur primaire. L'allure de ce courant est parfaitement centrée autour du zéro de courant.

Si par contre un courant circule dans le conducteur primaire un déséquilibre est créé au niveau du cycle d'hystérésis, la saturation arrivera plus tôt, du côté du déséquilibre. Ce déséquilibre va se traduire au niveau du courant secondaire, par l'apparition d'un courant moyen.

Ce courant moyen est le reflet du courant primaire. Sa valeur est donnée par l'équation de transformation :

$$I\sec = \frac{Nprim}{N\sec} \cdot Iprim.$$

Dans l'invention on extrait ce courant moyen Isec ce qui permet de déduire la valeur du courant à mesurer Iprim. L'extraction est réalisée en intégrant le courant Isec.

L'invention a donc pour objet un dispositif capteur de courant divulgué par la revendication 1.

Dans une variante l'invention le dispositif selon l'invention est aussi caractérisé en ce que le tore magnétique est de section fine, de l'ordre du micromètre.

Dans une variante le dispositif selon l'invention est aussi caractérisé en ce que le nombre de spires de l'enroulement primaire vaut 1, c'est-à-dire qu'il s'agit d'un simple fil traversant le tore magnétique.

Dans une variante le dispositif selon l'invention est aussi caractérisé en ce que le nombre de spires de l'enroulement primaire est strictement supérieur à 1.

Dans une variante le dispositif selon l'invention est aussi caractérisé en ce que le nombre de spires de l'enroulement secondaire est de l'ordre du millier.

Dans une variante le dispositif selon l'invention est aussi caractérisé en ce que le circuit extracteur est un circuit intégrateur dont les entrées sont pour l'une la masse électrique, pour l'autre la borne de l'enroulement secondaire à laquelle est connectée la résistance de mesure, la sortie du circuit intégrateur étant connectée à la borne de la résistance de mesure qui n'est pas connectée à l'enroulement secondaire.

L'invention sera mieux comprise à la lecture de la description qui suit et à l'examen des figures qui l'accompagnent. Celles-ci sont présentées à titre indicatif et nullement limitatif de l'invention. Les figures montrent:

Figure 1 : une illustration d'un capteur de l'état de la technique.
Figure 2: une illustration d'un capteur générique selon l'invention.
Figure 3: une illustration d'une mise en oeuvre pratique d'un capteur selon l'invention.
Figure 4 : une illustration d'une réalisation matérielle d'un tore magnétique selon l'invention.
Figure 5 : une illustration corrélée de l'évolution des signaux Vosc, Vsec, Iprim et Vint dans le temps.

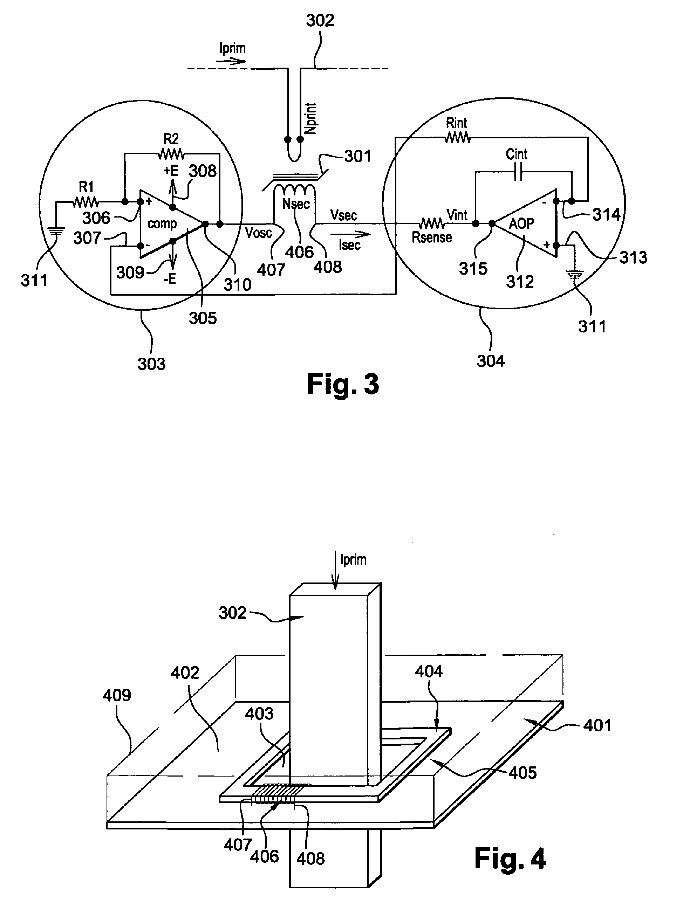

La figure 3 montre un conducteur 302 primaire, par exemple un fil électrique de section quelconque ou une piste sur circuit électronique, ce conducteur passe à travers un tore 301 magnétique formant ainsi une boucle de Nprim = 1 spire autour du tore 301. Ce conducteur est un enroulement primaire traversé par un courant Iprim qui doit être mesuré.

Dans une mise en oeuvre de l'invention le tore 301 a une section micrométrique, quelques dizaines de micromètres. La figure 4 illustre un tel tore.

Sur des figures différentes, des numéros identiques font références à des éléments identiques.

La figure 4 montre le conducteur 302 qui traverse, par un orifice central, un tore 401 mécanique de section carrée. Dans la pratique cette section pourrait être autre, circulaire ou rectangulaire par exemple. Le tore 401 est évidé en son centre par une ouverture 403.

Le tore 401 est formé de plusieurs éléments. Le tore 401 comporte un support 402 qui est formé dans un substrat amagnétique et électriquement non conducteur. Le support 402 a donc une section en couronne.

Le tore 401 comporte aussi, sur au moins l'une de ses faces, à proximité de l'ouverture 403 une boucle 404 magnétique fermée de dimensions micrométriques, quelques dizaines de micromètres dans la pratique. Cette boucle 404 est réalisée dans un matériel électromagnétique déposé sur le support 402 par un procédé de sérigraphie micrométrique, les plus courants de ces procédés étant:

- l'électrochimie,
- la pulvérisation,
- la pulvérisation et le traitement thermique dans le cas de l'utilisation de ferrites.

Le tore 401 comporte encore, déposé sur la boucle 404 une couche 405 isolante de quelques microns à quelques dizaines de microns d'épaisseur. Cette couche isolante est réalisée par un procédé de sérigraphie micrométrique, les plus courants pour cette opération étant:

- la photo lithographie pour les isolants de type polymères, ou
- le dépôt d'oxydes métalliques, par exemple SiO2 ou AL2O3.

Le tore 401 comporte enfin, enroulé autour du tore 404 un enroulement 406 de spires, correspondant à l'enroulement secondaire de l'invention, réalisé lui aussi par un procédé de sérigraphie micrométrique du type de ceux utilisés pour réaliser le tore 404. L'enroulement 406 comporte deux extrémités 407 et 408 auxquelles on connecte les autres éléments du capteur selon l'invention.

L'ensemble des tores 402, 404, 405 et 406 est recouvert par un moulage 409 de protection tel que ledit moulage isole les tores lesdits tores en laissant libre l'ouverture 403 et en laissant accessibles les extrémités 407 et 408 pour pouvoir y connecter les autres éléments de l'invention.

Ce montage permet de réaliser une bonne isolation entre le circuit dont on doit mesurer une grandeur et le circuit de mesure lui-même. On a donc bien un capteur de courant isolé.

La figure 3 montre un enroulement 406 secondaire comportant Nsec = 1000 de spires.

La figure 3 montre que l'extrémité 407 est connecté à un circuit 303 oscillateur et que l'extrémité 408 est connectée à un circuit 304 intégrateur.

La figure 3 montre que le circuit 303 oscillateur comporte un amplificateur 305 opérationnel. Cet amplificateur 305 opérationnel comporte:

- une entrée 306 non inverseuse,
- une entrée 307 inverseuse,
- une entrée 308 d'alimentation positive,
- une entrée 309 d'alimentation négative, et
- une sortie 310 délivrant une tension de sortie Vosc.

L'entrée 306 est connectée à une masse 311 électrique via une résistance R1.

L'entrée 306 est connectée à la sortie 310 via une résistance R2.

L'entrée 307 est directement connectée à l'extrémité 408.

L'entrée 308 est connectée à un potentiel +E..

L'entrée 309 est connectée à un potentiel -E.

La sortie 310 est connectée à l'extrémité 407.

La figure 3 montre que le circuit 304 intégrateur comporte un amplificateur 312 opérationnel. Cet amplificateur 312 opérationnel comporte:

- une entrée 313 non inverseuse,
- une entrée 314 inverseuse,
- une sortie 315 délivrant une tension de sortie Vint.

L'entrée 313 est connectée à la masse 311 électrique.

L'entrée 314 est connectée à l'extrémité 408 via une résistance Rint. L'entrée 314 est connectée à la sortie 315 via un condensateur Cint.

La sortie 315 est connectée à l'extrémité 408 via une résistance Rsense, qui est la résistance de mesure.

Pour ces circuits 303 et 304 les valeurs des composants varient énormément en fonction de l'application. On réalise cependant facilement un capteur avec R1, R2 et Rint de l'ordre de 10 Kohms, Rsens de l'ordre de 100 ohms et Cint de l'ordre de 10 nF.

En fonctionnement, le circuit 303 est un oscillateur de tension autonome. C'est un comparateur dont les entrées 307 inverseuse et 306 non inverseuse, oscillent entre E et -E. La réaction positive du système est assurée par le rebouclage de la sortie sur l'entrée non inverseuse par un gain G <1. On rappelle ici que dans le cas de ce montage le gain G vaut R1/(R1+R2).

Ainsi l'oscillateur de tension est un comparateur dont la tension de sortie peut varier entre +E et -E. Cette tension fait circuler un courant Isec dans l'enroulement 406. Ce courant amène à saturation le tore magnétique. La tension Vsec, augmente jusqu'à atteindre la tension

$$E \cdot \frac{R1}{R1+R2} \text{ ou } - E \cdot \frac{R1}{R1+R2}$$

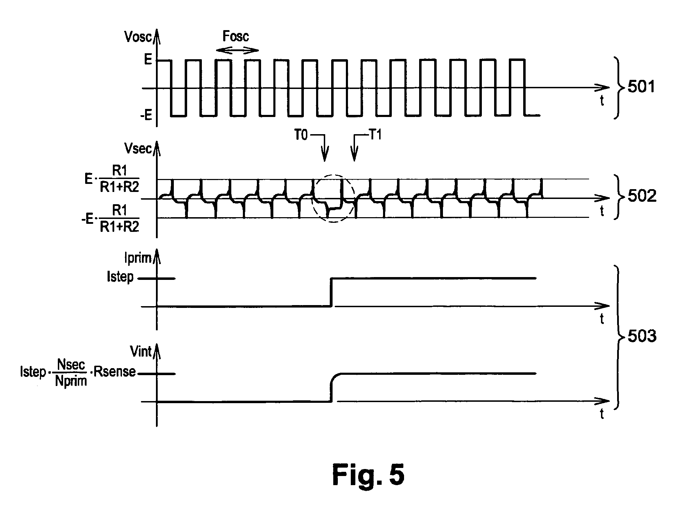

selon le cas. A ce moment, le comparateur bascule et la saturation part dans le sens inverse ainsi qu'illustré par la figure 5 qui montre que Vosc est une tension carrée de fréquence Fosc.

La fréquence d'oscillation (Fosc) est déterminée par la vitesse de saturation du tore magnétique. Cette fréquence est donnée par la loi de Faraday :

$$Fosc = \frac{2 \cdot E}{N \sec \cdot Ae \cdot \Delta B}$$

La figure 5 illustre aussi la tension Vsec en fonction de l'évolution de Vosc. La tension Vsec suit, avec une déformation due au tore magnétique, la tension Vosc. La tension Vosc a une valeur moyenne nulle, sauf lors d'une variation de courant dans le conducteur 302. Dans ce cas la tension Vsec est perturbée puis rétablie dans sa forme stable suite à l'action du circuit 304 intégrateur.

En fonctionnement, le circuit 304 est un système bouclé constitué d'un comparateur et d'une fonction « intégrateur » de gain Ki qui permet d'extraire l'image de la valeur moyenne du courant Iprim, soit le potentiel Vint. Cette tension est réinjectée sur Rsense, ce qui permet d'asservir l'oscillation au centre du cycle d'hystérésis en compensant le déséquilibre créé par les ampères-tours du courant primaire. On rappelle ici que dans le cas de ce montage le gain Ki vaut 1/(Rint * Cint).

Lorsqu'un courant circule (T0) dans le conducteur Nprim, on observe un décalage de la tension moyenne de Vsec. Cette tension est comparée à une consigne de valeur 0 volts. Le résultat de cette comparaison est compensé grâce à l'intégrateur. La sortie Vint est réinjectée sur Rsense de façon à annuler la composante moyenne.

Les diagrammes 502 et 503 de la figure 5 montrent l'effet d'un échelon de courant Istep sur Vsec. La valeur moyenne change, jusqu'à ce que la boucle de compensation réagissent et recentre (T1) la valeur moyenne de Vsec sur 0volts en injectant une tension Vint. La valeur de Vint est alors une image directe du courant à mesurer Iprim par relation fondamentale

$$V\text{int} = Rsense \cdot \frac{Nprim}{N\sec} \cdot Iprim$$

La mesure de Vint permet donc de connaître Iprim et ainsi d'obtenir la grandeur permettant le contrôle d'un dispositif.

De part sa construction physique on obtient de fait une séparation entre le conducteur 302 primaire et le circuit de mesure selon l'invention. On peut ainsi aisément obtenir une isolation électrique de plusieurs milliers de volts.

Le capteur selon l'invention permet d'atteindre des précisions supérieures aux autres procédés de mesure. La précision de la mesure est essentiellement liée à la précision de la résistance Rsense. C'est une résistance de faible puissance, que l'on peut facilement trouver dans des précisions de l'ordre de 0.1 %, et avec une sensibilité faible aux conditions de température.

Le principe de compensation des ampères tours avec un intégrateur permet d'extraire et de mesurer avec une erreur nulle. On compense directement les ampères tours et non une image de ceux ci à travers un capteur intermédiaire qui induit une erreur.

La dynamique du capteur est liée à la vitesse de parcours du cycle d'hystérésis. La loi de faraday impose une section efficace du tore de quelques dizaines de micromètres. Ceci est rendu possible grâce à un circuit magnétique sérigraphié. On peut alors obtenir une bande passante>100Khz.

Pas de problèmes d'offset magnétique, car par principe le tore est saturé continuellement. Il se magnétise et se démagnétise à chaque oscillation.

L'effet transformateur garantit une bonne linéarité.

L'intégrateur garantit qu'il n'y a pas d'effet d'offset au voisinage du zéro de courant.

Le capteur selon l'invention présente donc tous les avantages recherchés.

Il est donc possible d'employer le capteur selon l'invention dans des milieux industriels durs tels que les aéronefs. Parmi les utilisations possibles on site au moins :

- Les vérins électriques et actionneurs mettant en oeuvre des machines synchrones autopilotés à aimants permanents (moteurs « brushless ») (EMA, EABS frein électriques).
- Les dispositifs de type « pompe » électrique mettant en oeuvre des moteurs « brushless » autopilotés associés à une électronique de puissance (dispositif POMPE FUEL, pompe des EHA)
- Dispositif de protections d'interrupteurs de puissance (Disjoncteurs GFI, SEPDS, SSPC).
- Les convertisseurs de puissances de futur réseaux électriques avions. On peut citer les convertisseurs DC/DC pour réseaux à haute tension de type continu, les convertisseurs à absorption sinusoïdale encore appelés PFC.
- Les alimentations à découpage.

## Revendications

1. Dispositif capteur de courant comportant

 - un tore (301) magnétique
 - un enroulement (302) primaire dans lequel circule le courant à mesurer et enroulé autour du tore magnétique,
 - un enroulement (406) secondaire enroulé autour du tore magnétique,
 - un oscillateur (303) électronique connecté entre une masse (311) électrique et la première borne (407) de l'enroulement secondaire, et étant **caractérisé en ce qu'**il comporte
 - une résistance (Rsense) de mesure connectée entre la masse électrique et la deuxième borne (408) de l'enroulement secondaire via un circuit (304) extracteur, ledit circuit extracteur étant adapté à réinjecter sa tension de sortie sur la résistance de mesure (Rsense) de sorte à compenser un déséquilibre créé par les ampères-tours du courant circulant sur l'enroulement primaire.

2. Dispositif selon la revendication 1, dans lequel le tore magnétique est de section fine, de l'ordre du micromètre.

3. Dispositif selon l'une des revendications 1 ou 2, dans lequel le nombre de spires de l'enroulement primaire vaut 0, c'est-à-dire qu'il s'agit d'un simple fil traversant le tore magnétique.

4. Dispositif selon l'une des revendications 1 ou 2, dans lequel le nombre de spires de l'enroulement primaire est strictement supérieur à 1.

**5.** Dispositif selon l'une des revendications 1 à 4, dans lequel le nombre de spires de l'enroulement secondaire est de l'ordre du millier.

**6.** Dispositif selon l'une des revendications 1 à 5, dans lequel le circuit extracteur est un circuit intégrateur comprenant un amplificateur opérationnel (312) dont les entrées sont pour l'une la masse électrique, pour l'autre la borne de l'enroulement secondaire à laquelle est connectée la résistance de mesure, la sortie du comparateur étant connectée à la borne de la résistance de mesure qui n'est pas connectée à l'enroulement secondaire.

**7.** Dispositif selon l'une des revendications précédentes, dans lequel le circuit oscillateur (303) comporte un amplificateur opérationnel (305) dont la tension de sortie est destinée à porter le tore en saturation.

**Claims**

**1.** A current sensor device comprising:

    - a magnetic torus (301),
    - a primary coil (302) in which the current to be measured flows and winds around the magnetic torus,
    - a secondary coil (406) that winds around the magnetic torus,
    - an electronic oscillator (303) connected between an electrical ground (311) and a first terminal (407) of the secondary coil, being **characterized in that** it comprises:

        - a measurement resistor (Rsense) connected between the electrical ground and a second terminal (408) of the secondary coil via an extractor circuit (304), said extractor circuit being suitable for re-injecting its output voltage onto the measurement resistor (Rsense) so as to compensate for an imbalance created by the ampere-turns of the current flowing through the primary coil.

**2.** A device according to claim 1, **characterized in that** the magnetic torus is about one micrometer thin.

**3.** A device according to any one of claims 1 or 2, **characterized in that** the number of turns in the primary coil is equal to 0, which means that it is a simple wire traversing the magnetic torus.

**4.** A device according to any one of claims 1 or 2, **characterized in that** the number of turns in the primary coil is strictly greater than 1.

**5.** A device according to any one of claims 1 to 4, **char-**

**acterized in that** the number of turns in the secondary coil is around a thousand.

**6.** A device according to any one of claims 1 to 5, **characterized in that** the extractor circuit is an integrator circuit comprising an operational amplifier (312), whose inputs are the electrical ground and the terminal of the secondary coil, to which the measuring resistor is connected, the output of the operational amplifier being connected to the measuring resistor's terminal, which is not connected to the secondary coil.

**7.** A device according to any one of the previous claims, **characterized in that** the measurement oscillator circuit (303) comprises an operational amplifier (305), the output voltage of which being intended to saturate the torus.

**Patentansprüche**

**1.** Stromsensorvorrichtung mit

    - einem Magnetkern (301)
    - einer Primärwicklung (302), durch die der zu messende Strom fließt, und die um den Magnetkern gewickelt ist,
    - einer Sekundärwicklung (406), die um den Magnetkern gewickelt ist,
    - einem elektronischen Oszillator (303), der zwischen einer elektrischen Masse (311) und einer ersten Klemme (407) der Sekundärwicklung angeschlossen, und **dadurch gekennzeichnet ist, dass** sie

        -- einen Messwiderstand (Rsense) enthält, der über einen Extraktionskreis (304) zwischen der elektrischen Masse und einer zweiten Klemme (408) der Sekundärwicklung angeschlossen ist, wobei der besagte Extraktionskreis in der Lage ist, seine Ausgangsspannung so in den Messwiderstand (Rsense) zurück zu speisen, dass ein Ungleichgewicht ausgeglichen wird, das durch die Amperewindungen des Stromes entsteht, der durch die Primärwicklung fließt.

**2.** Vorrichtung nach Anspruch 1, bei der der Magnetkern einen feinen Querschnitt im Mikrometerbereich aufweist.

**3.** Vorrichtung nach einem der Ansprüche 1 oder 2, bei der die Anzahl der Windungen der Primärwicklung 0 wert ist, was bedeutet, dass es sich um einen einfachen Draht handelt, der durch den Magnetkern führt.

**4.** Vorrichtung nach einem der Ansprüche 1 oder 2, bei der die Anzahl der Windungen der Primärwicklung strikt über 1 liegt.

**5.** Vorrichtung nach einem der Ansprüche 1 bis 4, bei der die Anzahl der Windungen der Sekundärwicklung im Tausenderbereich liegt.

**6.** Vorrichtung nach einem der Ansprüche 1 bis 5, bei der der Extraktionskreis ein Integrationskreis mit einem Operationsverstärker (312) ist, dessen Eingänge einerseits die elektrische Masse und andererseits die Klemme der Sekundärwicklung sind, an die der Messwiderstand angeschlossen ist, wobei der Ausgang des Operationsverstärkers an die Klemme des Messwiderstands angeschlossen ist, die nicht an die Sekundärwicklung angeschlossen ist.

**7.** Vorrichtung nach einem der vorherigen Ansprüche, bei der der Oszillationskreis (303) einen Operationsverstärker (305) enthält, dessen Ausgangsspannung dazu bestimmt ist, den Kern in die Sättigung zu treiben.

102

103

104

101

Iprim

Vh

IC

+  -

Vsense

Is

106

105

## Fig. 1

202

Iprim

201

Vosc

E
-E

Isec

203

## Fig. 2

204

Rsense

205

**Fig. 3**

**Fig. 4**

Fig. 5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 2920484
- JP 04064068 B

- US 4529931 A